# EUROPEAN PATENT APPLICATION

(11) **EP 4 564 014 A1**
(43) Date of publication of application: **04.06.2025**
(21) Application number: 23212649.0
(22) Date of filing: 28.11.2023
(51) Int. Cl.: G01R 15/20

(54) **SENSOR DEVICE WITH TUNNEL MAGNETO-RESISTANCE SENSOR**

(71) Applicant: Lisa Dräxlmaier GmbH, 84137 Vilsbiburg (DE)
(72) Inventor: Grudzien, Szymon, 30-864 Kraków (PL)

(57) **Abstract**

The disclosure relates to a sensor device (100) for sensing a current (121) flowing through a busbar (120) in a battery-supplied vehicle, the sensor device (100) comprising: a carrier (110) configured for a placement above or under the busbar (120); and a Tunnel Magneto-Resistance, TMR, sensor (111) arranged on the carrier (110), the TMR sensor (111) being configured to sense a magnetic field (122) generated by the current (121) flowing through the busbar (120) and provide sensor data of the sensed magnetic field (122); wherein the TMR sensor (111) comprises a sensor interface (111a) configured to provide the sensor data to a controller (115) for determining the current (121) flowing through the busbar (120) based on the sensor data of the TMR sensor (111). The sensor device may comprise a second TMR sensor arranged on or above the carrier, the second TMR sensor being configured to sense the magnetic field and provide second sensor data of the sensed magnetic field; wherein the second TMR sensor comprises a sensor interface configured to provide the second sensor data to the controller for determining the current flowing through the busbar based on the second sensor data of the second TMR sensor. By using a second TMR sensor, sensing can be improved as two TMR sensors may cover wider measurement range than a single TMR sensor.

## Description

### TECHNICAL FIELD

The disclosure relates to a sensor device with a Tunnel Magneto-Resistance (TMR) sensor for sensing a current flowing through a busbar in a battery-supplied vehicle. In particular, the disclosure relates to a TMR-based current sensor for High Voltage (HV) batteries.

### BACKGROUND

Currently e-mobility market is rapidly growing. Especially in terms of battery-supplied vehicles high currents have to be handled. These high currents have to be measured for performance evaluation, power prediction and providing safety mechanisms for the end user. Current is usually measured by shunt sensor devices. The shunt sensor device is connected directly to the current path from the HV battery and voltage drop on a dedicated shunt resistor is measured. Disadvantages of such measurement are mainly the following: Cost of the device because of expensive, heavy interface to shunt resistor and a relatively complicated production process where current path connection has to be granted, the device is filled with resin or covered with conformal coating because of HV creepage and clearance distances, power losses on the shunt, especially for higher currents, and relatively significant dimensions of such devices. Potential mechanical strains are also high.

### SUMMARY

It is the object of this disclosure to provide a sensor device for sensing high currents of battery-supplied vehicles without the above-described disadvantages.

This object is achieved by the features of the independent claims. Further implementation forms are apparent from the dependent claims, the description and the figures.

To overcome the above-described problems the disclosure presents a new sensor device for sensing currents which is designed for replacement of the currently used shunt sensor. The new sensor device is based on one or more Tunnel Magneto-Resistance (TMR) sensors.

The new sensor device is compliant with market trends, innovative and robust. It provides an easier mechanical design than the shunt sensor device at a higher robustness. The new sensor device reduces costs and size and allows easier integration into HV battery than the shunt sensor. The new sensor device significantly reduces power dissipation.

The new sensor device is based on TMR sensors. Such TMR sensors give the following benefits: They are contactless sensors with high accuracy and short response time. Because of lack of direct contact with current path, potential mechanical failures are eliminated (strains from package). There is also almost no limit for the maximum current. These TMR sensors are protected against thermal runaway because they are not directly exposed to overcurrent. They are stable over temperature. Dimensions of the disclosed sensor device which is based on TMR sensors are reduced in comparison to a shunt sensor device. Power losses are reduced in comparison to the shunt sensor device. Production process is easier than in case of shunt-based sensor device in which integration of heavy shunt interface is problematic and additional processes are required such as potting, conformal coating, for example. Besides, TMR based solution is cheaper than shunt-based solution in terms of material, size and production costs.

In this disclosure TMR sensors are described. Magneto-Resistance is the property of a device to change its electrical value under a magnetic field. This effect is observed in ferromagnetic materials. These are materials that have magnetic properties. Metals like iron, nickel and cobalt are ferromagnetic while copper is not a ferromagnetic material. Changing the magnetization of the material affects how the electrons travel inside the material, thus changing the electrical resistance of the device.

Tunnel Magneto-Resistance (TMR) requires the use of an extremely thin non-magnetic and non-conducting insulation layer between two ferromagnetic layers. If the insulating layer is thin enough, typically a few nanometers, electrons can tunnel from one ferromagnetic layer into the other. Since this process is forbidden in classical physics, the Tunnel Magneto-Resistance is a strictly quantum mechanical phenomenon. TMR offers the best sensitivity compared to Hall effect, Anisotropic Magneto-Resistance (AMR) and Giant Magneto-Resistance (GMR).

The TMR sensor can be implemented, for example, as a sensor bridge which is biased with a constant voltage. A TMR sensor may consist of four TMR resistors that are sensitive to a magnetic field. Each TMR resistor can be constructed from a number of TMR elements. Four such TMR resistors may be connected in a Wheatstone bridge circuit. The Wheatstone bridge is sensitive to north/south orientation of magnetic field. The TMR sensor produces a differential analog signal that can be digitized by an Analog-Digital converter, for example, in order to allow further numerical calculations.

According to a first aspect, the disclosure relates to a sensor device for sensing a current flowing through a busbar in a battery-supplied vehicle, the sensor device comprising: a carrier configured for a placement above or under the busbar; and a Tunnel Magneto-Resistance (TMR) sensor arranged on the carrier, the TMR sensor being configured to sense a magnetic field generated by the current flowing through the busbar and provide sensor data of the sensed magnetic field; wherein the TMR sensor comprises a sensor interface configured to provide the sensor data to a controller for determining the current flowing through the busbar based on the sensor data of the TMR sensor.

Such a sensor device, that is based on a Tunnel Magneto-Resistance (TMR) sensor, can be used for sensing currents. The sensor device can replace the currently used shunt sensor. The new sensor device is compliant with market trends, innovative and robust. The sensor device provides an easier mechanical design than the shunt sensor device at a higher robustness. Thus, the sensor device can reduce costs and size and allows easier integration into HV battery than a shunt sensor. The new sensor device with TMR sensor significantly reduces power dissipation.

In an exemplary implementation of the sensor device, the sensor device comprises: a second TMR sensor arranged on or above the carrier, the second TMR sensor being configured to sense the magnetic field and provide second sensor data of the sensed magnetic field; wherein the second TMR sensor comprises a sensor interface configured to provide the second sensor data to the controller for determining the current flowing through the busbar based on the second sensor data of the second TMR sensor.

By using a second TMR sensor, sensing can be improved as two TMR sensors may cover wider measurement range than a single TMR sensor. Besides, the second TMR sensor can be used for redundancy purposes. Another advantage is that the second TMR sensor can, depending on the distance to the source of the magnetic field, provide another sensor resolution and avoid overdriving when the first TMR sensor is already overdriven.

In an exemplary implementation of the sensor device, a sensing resolution of the TMR sensor corresponds to a sensing resolution of the second TMR sensor; and/or the TMR sensor is identical in construction to the second TMR sensor.

This provides the advantage that manufacture of two equal TMR sensors is easy. When the magnetic field's measurement range of both TMR sensors is the same, the current measurement range only depends on the distance to the source of the magnetic field which corresponds to the conductor (busbar) with current flowing through it and sensitivity for existing magnetic field. This distance can be controlled by design of the sensor device, i.e., by placement of the two sensors on the printed circuit board (the carrier).

In an exemplary implementation of the sensor device, the TMR sensor is configured for being arranged in a first position towards the busbar and the second TMR sensor is configured for being arranged in a second position towards the busbar; wherein a strength of the magnetic field in the first position is different to a strength of the magnetic field in the second position.

This provides the technical advantage that the two sensors can be placed at different positions towards the busbar and hence towards the magnetic. This improves measurement range since two different sensing data can be used. The positions of the TMR sensors can be designed in such way that when one of the sensing data of the TMR sensors is overdriven, the other sensing data is not overdriven and can be used for sensing the current flowing through the busbar.

In an exemplary implementation of the sensor device, the sensor device comprises: the controller configured to receive the sensor data from the TMR sensor and the second sensor data from the second TMR sensor; wherein the controller is configured to detect an overdriving of the sensing resolution of the TMR sensor by the magnetic field based on the sensor data.

The controller can be part of the sensor device, or it can be part of an external control device. The controller can be used for performing high complex processing such that the two sensors can have a less complex design. The controller can detect an overdriving of the sensing resolution based on the sensor data, so the TM R sensor can just sense without doing anything else. The controller is able to detect the overdriving directly or it can be detected by an external controller based on information from the two sensors (decision can be made internally or externally).
In an exemplary implementation of the sensor device, the controller is configured to determine the current flowing through the busbar based on the sensor data and the second sensor data if no overdriving is detected and based on the second sensor data if the overdriving is detected.

The controller can provide the sensed current based on the sensing data of the one or two TMR sensors. Hence, the complex processing of providing the sensed current from the sensed magnetic field data can be shifted from the TMR sensor to the controller.

In an exemplary implementation of the sensor device, the TMR sensor is arranged at a first distance to the busbar and the second TMR sensor is arranged at a second distance to the busbar.

Depending on the distance to the busbar, the resolution of the magnetic field received by the sensors differs. Thus, if the first sensor's resolution is overdriving, the second sensor's resolution is not overdriving.

In an exemplary implementation of the sensor device, the second distance is greater than the first distance. For example, the second distance can be twice the first distance or 1.5 times the first distance or 3 times the first distance. It understands that any other value for the second distance that is greater than the first distance can be used as well.

This enables that the first TMR sensor receives a different strength of the magnetic field than the second TMR sensor. Thus if the first sensor's resolution is overdriving, the second sensor's resolution is good.

In an exemplary implementation of the sensor device, the sensor device comprises: an encapsulant encapsulating the carrier and the TMR sensors, the encapsulant having a main surface being configured for placement on the busbar; wherein the encapsulant is dimensioned to arrange the TMR sensor at the first distance to the busbar and the second TMR sensor at the second distance to the busbar.

The encapsulant provides the advantage that it can be connected, e.g., clipped with the busbar. Depending on the design of the encapsulant, different distances of the first TMR sensor and the second TMR sensor to the busbar can be realized.

In an exemplary implementation of the sensor device, the sensor device comprises: a second carrier arranged above the carrier, wherein the second TMR sensor is placed on the second carrier.

By this second carrier, the distance of the second TMR sensor to the busbar can be designed to be different than the distance of the first TMR sensor to the busbar.

In an exemplary implementation of the sensor device, the sensor device comprises: one or more spacers mounted between the carrier and the second carrier, wherein a height of the spacers is dimensioned to place the second TMR sensor on the second carrier at the second distance to the busbar.

The spacers can also be used to design the distance of the first TMR sensor to the busbar and the distance of the second TMR sensor to the busbar.

In an exemplary implementation of the sensor device, both TMR sensors are placed on the carrier; wherein an offset of the TMR sensor towards the busbar is different from an offset of the second TMR sensor towards the busbar.

The offsets can be designed differently, this enables the two TMR sensors receiving a different strength of the magnetic field.

In an exemplary implementation of the sensor device, the sensor device comprises: a shielding plate placed on the carrier, the shielding plate being non-transparent to the magnetic field; wherein the second TMR sensor is separated from the busbar with the shielding plate.

By such shielding plate, the second TMR sensor can receive a weaker magnetic field than the first TMR sensor. This provides the desired variability in the sensor data.

In an exemplary implementation of the sensor device, the TMR sensor is placed on a top face of the carrier; and the second TMR sensor is placed on a bottom face of the carrier, the bottom face being opposite to the top face.

By such placing on different faces of the carrier, the distances of the first and second TMR sensor to the busbar can be designed different. Hence, a different strength of the magnetic field can be sensed by both TMR sensors.

In an exemplary implementation of the sensor device, both TMR sensors are placed on the carrier; wherein a position of the second TMR sensor on the carrier is rotated with respect to a position of the TMR sensor on the carrier.

The rotation for the positions of both TMR sensors can be designed to be different, this enables the two TMR sensors receiving a different strength of the magnetic field.

In an exemplary implementation of the sensor device, the controller comprises a calibration interface for receiving calibration data, the controller being configured to determine the current flowing through the busbar depending on the calibration data.

This provides the advantage that a potential calibration for the overall setup can be applied, not for each particular TMR sensor itself. Note that the TMR sensors are calibrated by default on their production line.

In an exemplary implementation of the sensor device, the controller comprises a communication interface for providing information about the current flowing through the busbar to a communication system.

This provides the advantage that the sensed current can be provided to external systems like a communication system for further evaluation.

According to a second aspect, the disclosure relates to a method for sensing a current flowing through a busbar in a battery-supplied vehicle, the method comprising: placing a carrier with a Tunnel Magneto-Resistance (TMR) sensor above or under the busbar; sensing a magnetic field generated by the current flowing through the busbar by the TMR sensor; and providing sensor data of the sensed magnetic field by a sensor interface of the TMR sensor to a controller for determining the current flowing through the busbar based on the sensor data of the TMR sensor.

Such a current sensing method that is based on a Tunnel Magneto-Resistance (TMR) sensor can replace currently used sensing methods that are based on shunt sensors. The new sensing method is innovative and robust. The new sensing method by means of a TMR sensor significantly reduces power dissipation.

In an exemplary implementation of the sensing method, a second TMR sensor is arranged on or above the carrier and the method further comprises: sensing the magnetic field by the second TMR sensor; and providing second sensor data of the sensed magnetic field by a sensor interface of the second TMR sensor to the controller for determining the current flowing through the busbar based on the second sensor data of the second TMR sensor.

By using a second TMR sensor, the sensing method can be improved as two TMR sensors may cover wider measurement range than a single TMR sensor. Besides, the sensing method can use the second TMR sensor for redundancy purposes. Another advantage is that the second TMR sensor can, depending on the distance to the source of the magnetic field, provide another sensor resolution and avoid overdriving when the first TMR sensor is already overdriven. Thus, the sensing method is very robust and precise.

In an exemplary implementation of the sensing method, a sensing resolution of the TMR sensor corresponds to a sensing resolution of the second TMR sensor; and/or the TMR sensor is identical in construction to the second TMR sensor.

This provides the advantage that when the magnetic field's measurement range of both TMR sensors is the same, the current measurement range only depends on the distance to the source of the magnetic field. By using different distances for the two TMR sensors, the sensing method is very robust against distortions and overdriving.

According to a third aspect, the disclosure relates to a sensing arrangement, comprising the sensor device according to the first aspect and/or its implementation forms and the busbar; wherein the carrier of the sensor device is placed above or under the busbar.

This provides the advantage that the sensor device can accurately sense the current flowing through the busbar.

In an exemplary implementation of the sensing arrangement, the TMR sensor is arranged in a first position towards the busbar and the second TMR sensor is arranged in a second position towards the busbar; wherein a strength of the magnetic field in the first position is different to a strength of the magnetic field in the second position.

### BRIEF DESCRIPTION OF THE DRAWINGS

Further examples will be described with respect to the following figures, in which:
Fig. 1 shows a block diagram of a sensor device 100 according to the disclosure;
Fig. 2 shows a cross section of the sensor device 100 according to a first embodiment;
Fig. 3 shows a top view of the sensor device 100 according to a second embodiment;
Fig. 4 shows a top view of the sensor device 100 according to a third embodiment;
Fig. 5 shows a cross section of the sensor device 100 according to a fourth embodiment;
Fig. 6 shows a top view of the sensor device 100 according to a fifth embodiment; and
Fig. 7 shows a schematic diagram illustrating a sensing method 700 according to the disclosure.

### DETAILED DESCRIPTION OF EMBODIMENTS

In the following detailed description, reference is made to the accompanying drawings, which form a part thereof, and in which is shown by way of illustration specific aspects in which the disclosure may be practiced. It is understood that other aspects may be utilized and structural or logical changes may be made without departing from the scope of the present disclosure. The following detailed description, therefore, is not to be taken in a limiting sense, and the scope of the present disclosure is defined by the appended claims.

It is understood that comments made in connection with a described method may also hold true for a corresponding device or system configured to perform the method and vice versa. Further, it is understood that the features of the various exemplary aspects described herein may be combined with each other, unless specifically noted otherwise.

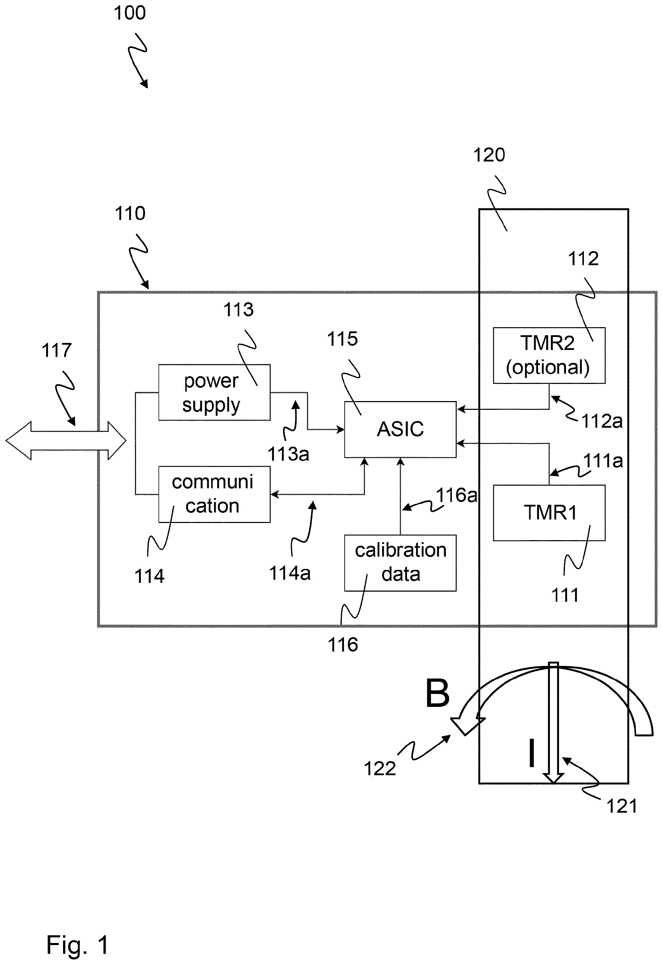

Fig. 1 shows a block diagram of a sensor device 100 according to the disclosure.

The sensor device 100 can be used for sensing a current 121 flowing through a busbar 120 in a battery-supplied vehicle.

The sensor device 100 comprises a carrier 110 configured for a placement above (or below) the busbar 120; and a Tunnel Magneto-Resistance (TMR) sensor 111 arranged on the carrier 110. The carrier 110 can be a Printed Circuit Board (PCB), for example. The TMR sensor 111 is configured to sense a magnetic field 122 generated by the current 121 flowing through the busbar 120 and provide sensor data of the sensed magnetic field 122. The carrier 110 can be placed above the busbar 120 or below the busbar 120. The TMR sensor 111 is arranged on the carrier 110, this means it can be placed on a top face of the carrier or on a bottom face of the carrier 110.

The TMR sensor 111 comprises a sensor interface 111a configured to provide the sensor data to a controller 115 for determining the current 121 flowing through the busbar 120 based on the sensor data of the TMR sensor 111. The controller 115 can be a driver chipset, like the ASIC shown in Figure 1, or it can be a controller externally of the sensor device 110, in this case the sensor data is provided by the ASIC 115 and a communication circuit 114 to the external interface 117 and then to an external controller.

The sensor device 100 may comprise an (optional) second TMR sensor 112 arranged on or above the carrier 110. The second TMR sensor 112 is configured to sense the magnetic field 122 and provide second sensor data of the sensed magnetic field 122. The second TMR sensor 112 can sense the same magnetic field 122 but located at another position than the TM R sensor 111, thus different field lines of the magnetic field 122 are sensed by the second TMR sensor 112.

The second TMR sensor 112 comprises a sensor interface 112a configured to provide the second sensor data to the controller 115 for determining the current 121 flowing through the busbar 120 based on the second sensor data of the second TMR sensor 112. Thus, a wider measurement range can be applied when using two TM R sensors 111, 112 placed at different positions.

A sensing resolution of the TMR sensor 111 may correspond to a sensing resolution of the second TMR sensor 112; and/or the TMR sensor 111 can be identical in construction to the second TMR sensor 112. In the latter case it understands that both sensing resolutions are equal.

The TMR sensor 111 may be configured for being arranged in a first position towards the busbar 120 and the second TMR sensor 112 may be configured for being arranged in a second position towards the busbar 120. A strength of the magnetic field 122 in the first position can be different to a strength of the magnetic field 122 in the second position, e.g., weaker in the second position.

The sensor device 100 can comprise such a controller or sensor driver 115 which may be configured to receive the sensor data from the TMR sensor 111 and the second sensor data from the second TMR sensor 112. The controller or sensor driver 115 may be configured to detect an overdriving of the sensing resolution of the TMR sensor 111 by the magnetic field 122 based on the sensor data.

The controller or sensor driver 115 may be configured to determine the current 121 flowing through the busbar 120 based on the sensor data and the second sensor data if no overdriving is detected and based on the second sensor data if the overdriving is detected. Thus, measurement range can be improved. Besides, when having valid measures from both two TMR sensors, redundancy can be implemented, e.g., according to requirements for ASIL related applications.

The TMR sensor 111 may for example be arranged at a first distance 201 to the busbar 120 and the second TMR sensor 112 may for example be arranged at a second distance 202 to the busbar 120. The second distance 202 can be for example greater than the first distance 201, it can be for example twice the first distance 201 or three-times or four-times or five-times the first distance 201. The second distance 202 can be predefined in such a way that in the second distance no overdriving of the second TMR sensor can occur.

The sensor device 100 may further comprise: an encapsulant 220 encapsulating the carrier 110 and the TMR sensors 111, 112. The encapsulant 220 comprises a main surface being configured for placement on the busbar 120. The encapsulant 220 can be an electrically insulating material, e.g., a mold compound or a plastic material that optionally inhibits the TMR sensors 111, 112 from contacting the busbar 120.

The encapsulant 220 is dimensioned to arrange the TMR sensor 111 at the first distance 201 to the busbar 120 (or at the first position towards the busbar 120 as mentioned above) and the second TMR sensor 112 at the second distance 202 to the busbar 120 (or at the second position towards the busbar 120 as mentioned above).

In the example of Figure 1, the controller or sensor driver implemented within the ASIC 115 may comprises a calibration interface 116a for receiving calibration data 116. The controller or sensor driver 115 may be configured to determine the current 121 flowing through the busbar 120 depending on the calibration data 116.

In the example of Figure 1, the controller or sensor driver 115 may comprise a communication circuit 114 for providing information about the current 121 flowing through the busbar 120 to a communication system via a communication interface 117.

In the example of Figure 1, the controller or sensor driver 115 may comprise a power supply interface 113a for providing the controller or sensor driver 115 with power from a power supply 113.

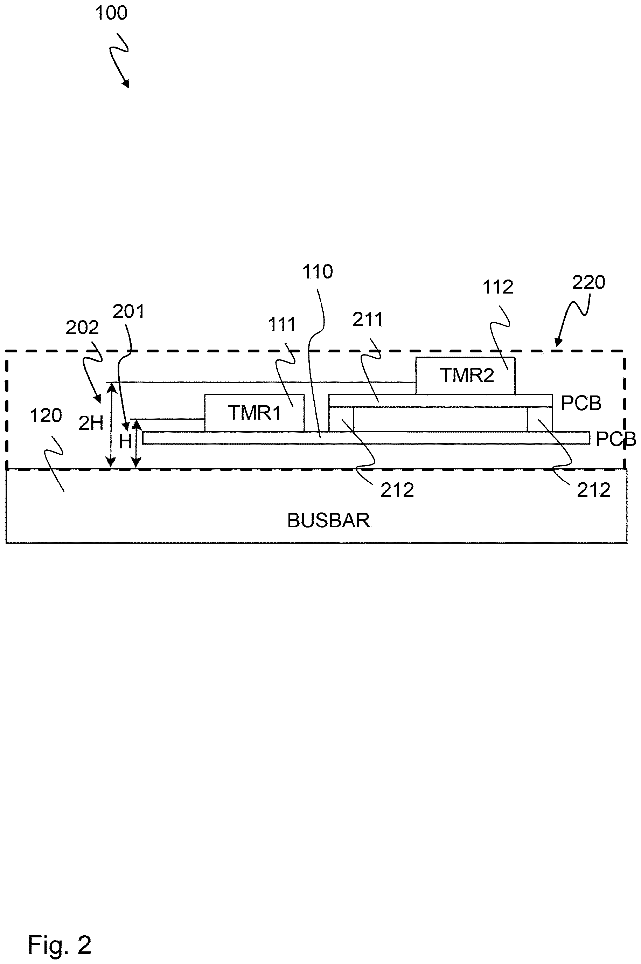

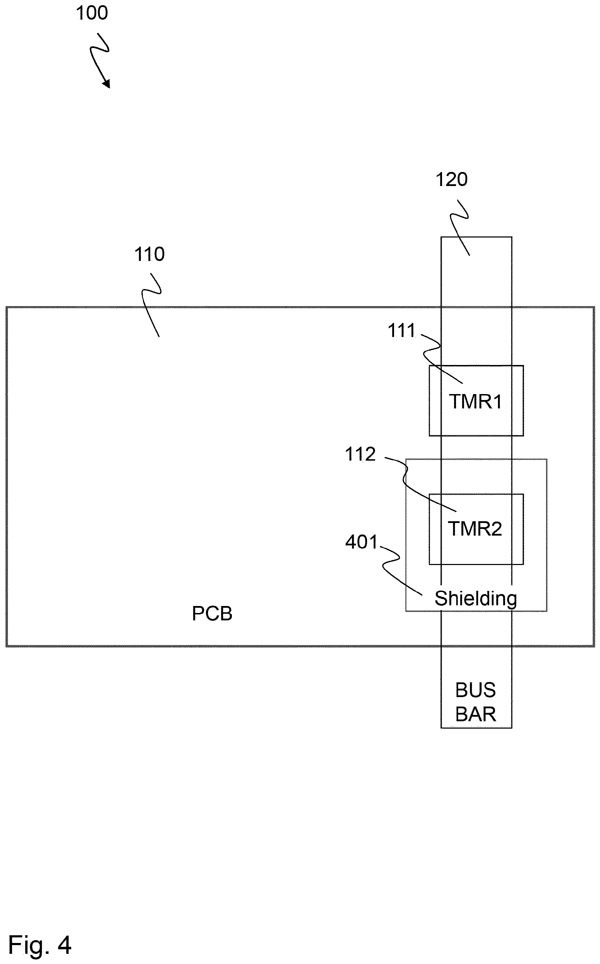

The concept for the new sensor device is to integrate two TM R sensors 111, 112 in one device 100, where the first TMR sensor 111 is a "must have", while the second TMR sensor 112 is optional. Different distance can be applied between each sensor 111, 112 and the busbar 120 in order to increase measurement range for peak currents, e.g., 2 times bigger distance for the second TMR sensor 112 for sensing of peak currents. The second TMR sensor 112 can be assembled on a separated PCB 211 (e.g., as shown in Figure 2). An option with PCB-integrated shielding 401 to reduce magnetic field for the second sensor while keeping the same distance can also be implemented (e.g., as shown in Figure 4).

For the new concept, a shunt is not required any longer. The sensor that is located in further distance (with reduced magnetic field) can act also as a redundancy (with lower accuracy) to the closer one. Typical UIR (Voltage Current Resistance) sensor drivers (from different manufacturers) can be used as a base (ASIC) 115. The TMR sensor can replace directly a shunt resistor. The redundant sensor can be connected to an extra ADC channel of the ASIC 115 or can be directly connected to a shunt-dedicated channel (3 channels can be available). The complete module (sensor device 100) can be clipped on the busbar 120.

The sensor device 100 as described in this disclosure can be applied in a sensing arrangement for sensing a current flowing through a busbar in a battery-supplied vehicle. Such a sensing arrangement comprises the sensor device 100 and the busbar 120 as described above; wherein the carrier 110 of the sensor device 100 is placed above or under the busbar 120. Such a sensing arrangement can accurately sense the current flowing through the busbar 120.

The TMR sensor 111 of the sensing arrangement can be arranged in a first position towards the busbar 120 and the second TMR sensor 112 of the sensing arrangement can be arranged in a second position towards the busbar 120, e.g., as shown in Figure 1 and in Figures 2 to 6. A strength of the magnetic field in the first position may be different to a strength of the magnetic field in the second position.

Fig. 2 shows a cross section of the sensor device 100 according to a first embodiment.

The sensor device 100 may correspond to the sensor device 100 shown in Figure 1. In this cross view, the sensor device 100 comprises a (first) carrier 110, e.g. a PCB, configured for a placement above or under the busbar 120. The (first) TMR sensor 111 can be arranged on the carrier 110 as shown in Figure 2. In particular, the first TMR sensor can be placed on the carrier 110 at a first distance (H) 201 to the busbar 120.

The sensor device 100 comprises a second carrier 211, e.g., another PCB, arranged above the first carrier 110. The second TMR sensor 112 can be placed on the second carrier 211.

The sensor device 100 may comprise: one or more spacers 212 mounted between the carrier 110 and the second carrier 211. A height of the spacers 212 is dimensioned to place the second TMR sensor 112 on the second carrier 211 at a second distance (2H) 202 to the busbar 120. This second distance 202 can be twice the first distance 201, for example, as shown in Figure 2 or any other value greater than the first distance 201.

The sensor device 100 may comprise an encapsulant 220 encapsulating the carrier 110 and the TMR sensors 111, 112 and also the second carrier 211 with the second TMR sensor 112 and the spacers 212. The encapsulant 220 comprises a main surface being configured for placement on the busbar 120. As described above with respect to Figure 1, the encapsulant 220 can be an electrically insulating material, e.g., a mold compound or a plastic material. In an optional design, this encapsulant 220 can inhibit the TMR sensors 111, 112 from contacting the busbar 120. The encapsulant 220 is dimensioned to arrange the TMR sensor 111 at the first distance 201 to the busbar 120 (or at the first position towards the busbar 120 as mentioned above) and the second TMR sensor 112 at the second distance 202 to the busbar 120 (or at the second position towards the busbar 120 as mentioned above).

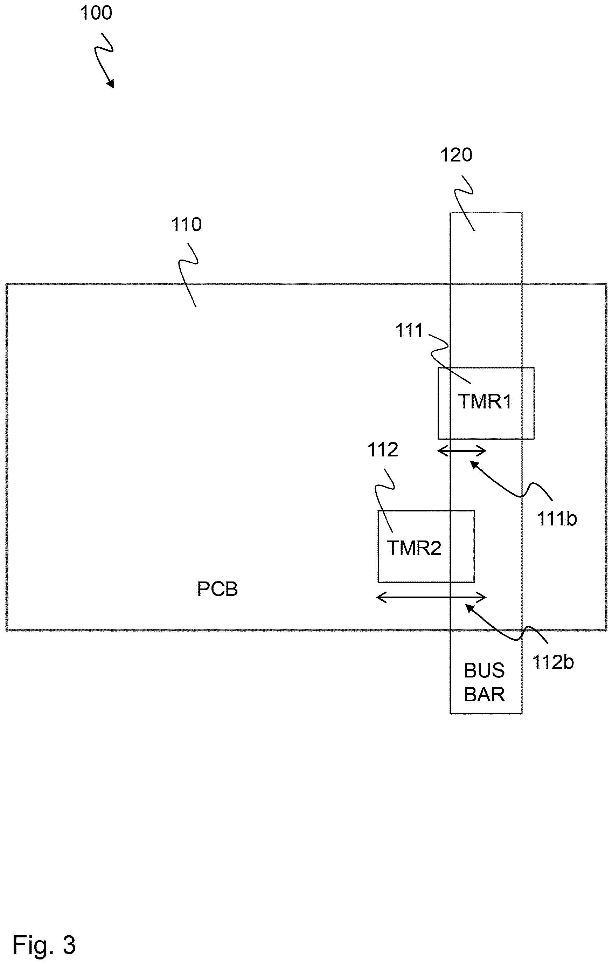

Fig. 3 shows a top view of the sensor device 100 according to a second embodiment.

The sensor device 100 may correspond to the sensor device 100 shown in Figure 1. In this top view, the sensor device 100 comprises a (first) carrier 110, e.g. a PCB, configured for a placement above or under the busbar 120.

Both TMR sensors 111, 112 can be placed on the carrier 110. In this embodiment, the first TMR sensor 111 can be placed on the carrier 110 with an offset towards the busbar 120, i.e., with an offset to a longitudinal direction or axis of the busbar 120 as shown in Figure 3. The second TMR sensor 112 can be placed on the carrier 110 with a second offset towards the busbar 120.

The second offset 112b can be different to the first offset 111b, as exemplarily shown in Figure 3. This results in a different strength of the magnetic field 122 sensed by the two TMR sensors 111, 112. In particular, the magnetic field 122 sensed by the second TMR sensor 112 is weaker than the magnetic field 122 sensed by the first TMR sensor 111. Hence, if the magnetic field 122 is strong at the position of the first TMR sensor 111 resulting in an overdriving of the sensing resolution of the first TMR sensor 111, the magnetic field 122 at the position of the second TM R sensor 112 is weaker such that the sensing resolution of the second TM R sensor 112 is not being overdriven.

Fig. 4 shows a top view of the sensor device 100 according to a third embodiment.

The sensor device 100 may correspond to the sensor device 100 shown in Figure 1. In this top view, the sensor device 100 comprises a (first) carrier 110, e.g., a PCB, configured for a placement above or under the busbar 120.

The sensor device 100 may comprise a shielding plate 410 or a shieling layer placed on the carrier 110. The shielding plate 410 or shielding layer is non-transparent or only weak-transparent to the magnetic field 122. The second TMR sensor 112 can be separated from the busbar 120 with the shielding plate 401 as shown here in Figure 4. The shielding plate 401 can be on opposite or same side of the carrier 110 (e.g., PCB) like the second TMR sensor 112. However, it has to be placed in between the second TMR sensor 112 and the busbar 120.

This results in a different strength of the magnetic field 122 sensed by the two TMR sensors 111, 112. In particular, the magnetic field 122 sensed by the second TMR sensor 112 is weaker than the magnetic field 122 sensed by the first TMR sensor 111 due to the shielding of the magnetic field 122 by the shielding plate 401. Hence, if the magnetic field 122 is strong at the position of the first TMR sensor 111 resulting in an overdriving of the sensing resolution of the first TMR sensor 111, the magnetic field 122 at the position of the second TMR sensor 112 on the shielding plate 401 is weaker such that the sensing resolution of the second TMR sensor 112 is not in overdrive.

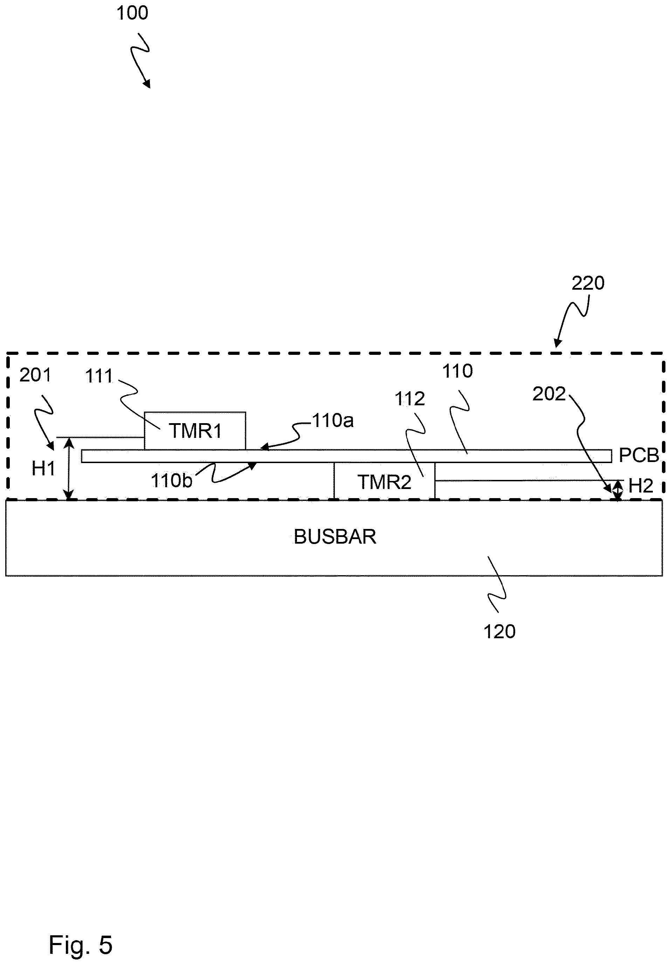

Fig. 5 shows a cross section of the sensor device 100 according to a fourth embodiment.

The sensor device 100 may correspond to the sensor device 100 shown in Figure 1. In this cross view, the sensor device 100 comprises the (first) carrier 110, e.g., a PCB, configured for a placement above or under the busbar 120.

The TMR sensor 111 can be placed on a top face 110a of the carrier 110; and the second TMR sensor 112 can be placed on a bottom face 110b of the carrier 110. This bottom face 110b is opposite to the top face 110a.

In this configuration, a first distance 201 from the first TMR sensor 111 to the busbar 120 can be H1 and a second distance 202 from the second TMR sensor 112 to the busbar 120 can be H2. In this example H2 is different from H1 resulting in a different strength of the magnetic field 122 sensed by the first TMR sensor 111 and the second TMR sensor 112.

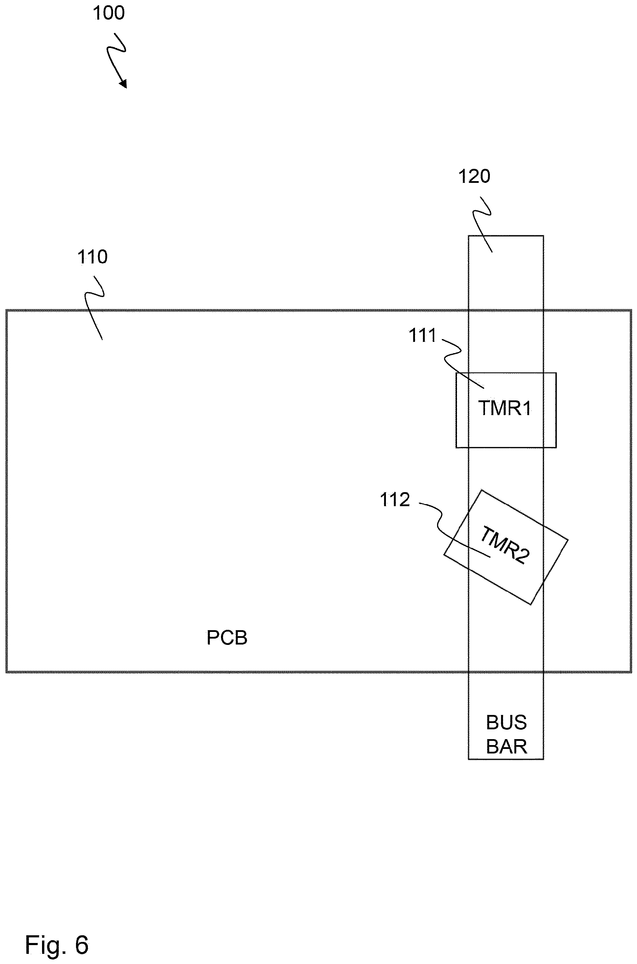

Fig. 6 shows a top view of the sensor device 100 according to a fifth embodiment.

The sensor device 100 may correspond to the sensor device 100 shown in Figure 1. In this top view, both TMR sensors 111, 112 are placed on the (first) carrier 110.

A position of the second TM R sensor 112 on the carrier 110 is rotated with respect to a position of the TMR sensor 111 on the carrier 110.

In this example, the direction of the first TMR sensor 111 with respect to a direction of the magnetic field 122 is different from a direction of the second TMR sensor 112 resulting in a different strength of the magnetic field 122 sensed by the first TM R sensor 111 and the second TMR sensor 112.

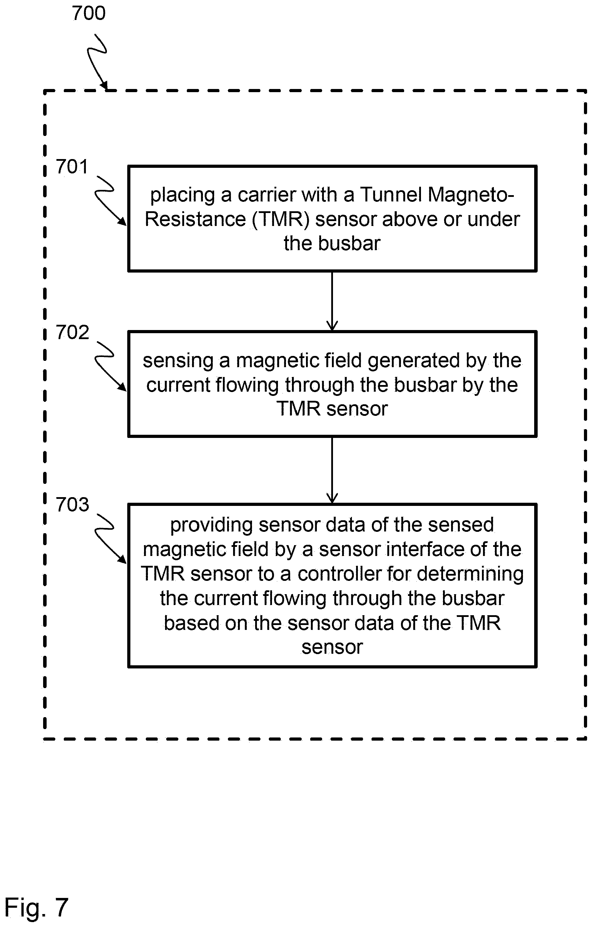

Fig. 7 shows a schematic diagram illustrating a sensing method 700 according to the disclosure. The method 700 can be used for sensing a current flowing through a busbar 120 in a battery-supplied vehicle.

The method 700 comprises: placing 701 a carrier with a Tunnel Magneto-Resistance (TMR) sensor above or under the busbar 120; sensing 702 a magnetic field generated by the current flowing through the busbar 120 by the TMR sensor 111; and providing 703 sensor data of the sensed magnetic field by a sensor interface of the TMR sensor 111 to a controller 115 for determining the current flowing through the busbar based on the sensor data of the TMR sensor.

Such a current sensing method 700 that uses a TMR sensor can efficiently replace currently used sensing methods that are using shunt sensors. The new sensing method 700 is innovative and robust and significantly reduces power dissipation.

For the method 700, the first step, i.e., placing 701 the carrier 110 above or under the busbar 120 is not necessary. The carrier 110 may already be placed above or under the busbar 120 when the method 700 is performed. Hence this first step 701 is optional for the method 700.

A second TMR sensor 112 can be arranged on or above the carrier, e.g., as shown above with respect to Figures 1 to 6. The method 700 may further comprise: sensing the magnetic field by the second TMR sensor 112; and providing second sensor data of the sensed magnetic field by a sensor interface of the second TMR sensor 112 to the controller for determining the current flowing through the busbar 120 based on the second sensor data of the second TMR sensor 112, e.g., as described above with respect to Figures 1 to 6.

By using the second TMR sensor 112, the sensing method 700 can be improved as two TMR sensors 111, 112 may cover wider measurement range than a single TMR sensor. Besides, the sensing method 700 can use the second TMR sensor 112 for redundancy purposes.

Besides, the second TMR sensor 112 can, depending on the distance to the source of the magnetic field, provide another sensor resolution and avoid overdriving when the first TMR sensor 111 is already overdriven. Thus, the sensing method 700 is very robust and precise.

In an exemplary implementation of the sensing method 700, a sensing resolution of the TMR sensor 111 corresponds to a sensing resolution of the second TMR sensor 112; and/or the TMR sensor 111 is identical in construction to the second TMR sensor 112, e.g., as described above with respect to Figures 1 to 6.

While a particular feature or aspect of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

Although specific aspects have been illustrated and described herein, it will be appreciated by those of ordinary skill in the art that a variety of alternate and/or equivalent implementations may be substituted for the specific aspects shown and described without departing from the scope of the present disclosure. This application is intended to cover any adaptations or variations of the specific aspects discussed herein.

Although the elements in the following claims are recited in a particular sequence with corresponding labeling, unless the claim recitations otherwise imply a particular sequence for implementing some or all of those elements, those elements are not necessarily intended to be limited to being implemented in that particular sequence.

Many alternatives, modifications, and variations will be apparent to those skilled in the art in light of the above teachings. Of course, those skilled in the art readily recognize that there are numerous applications of the invention beyond those described herein. While the present invention has been described with reference to one or more particular embodiments, those skilled in the art recognize that many changes may be made thereto without departing from the scope of the present invention. It is therefore to be understood that within the scope of the appended claims and their equivalents, the invention may be practiced otherwise than as specifically described herein.

### LISTING OF REFERENCE SIGNS

- 100: sensor device
- 110: (first) carrier or PCB
- 111: (first) TMR sensor
- 111a: sensor interface of (first) TMR sensor
- 112: second TMR sensor
- 112a: sensor interface of second TMR sensor
- 113: power supply
- 113a: power supply interface
- 114: communication circuit
- 114a: communication interface
- 115: ASIC or driver circuit
- 116: calibration data (storage)
- 116a: calibration data interface
- 117: external interface
- 120: busbar
- 121: current flowing through busbar
- 122: magnetic field generated by current flowing through busbar

- 201: distance between (first) TMR sensor and busbar
- 202: distance between second TMR sensor and busbar
- 211: second carrier or PCB
- 212: spacers
- 220: encapsulant
- 111b: offset of (first) TM R sensor towards busbar
- 112b: offset of second TMR sensor towards busbar
- 110a: top face of the (first) carrier
- 110b: bottom face of the (first) carrier

- 401: shielding plate or layer

- 700: sensing method
- 701: first step of sensing method: placing
- 702: second step of sensing method: sensing
- 703: third step of sensing method: providing

## Claims

1. A sensor device (100) for sensing a current (121) flowing through a busbar (120) in a battery-supplied vehicle, the sensor device (100) comprising:
a carrier (110) configured for a placement above or under the busbar (120); and
a Tunnel Magneto-Resistance, TMR, sensor (111) arranged on the carrier (110), the TMR sensor (111) being configured to sense a magnetic field (122) generated by the current (121) flowing through the busbar (120) and provide sensor data of the sensed magnetic field (122);
wherein the TMR sensor (111) comprises a sensor interface (111a) configured to provide the sensor data to a controller (115) for determining the current (121) flowing through the busbar (120) based on the sensor data of the TMR sensor (111).

2. The sensor device (100) of claim 1, comprising:
a second TMR sensor (112) arranged on or above the carrier (110), the second TMR sensor (112) being configured to sense the magnetic field (122) and provide second sensor data of the sensed magnetic field (122);
wherein the second TMR sensor (112) comprises a sensor interface (112a) configured to provide the second sensor data to the controller (115) for determining the current (121) flowing through the busbar (120) based on the second sensor data of the second TMR sensor (112).

3. The sensor device (100) of claim 2,
wherein a sensing resolution of the TMR sensor (111) corresponds to a sensing resolution of the second TMR sensor (112); and/or
wherein the TMR sensor (111) is identical in construction to the second TMR sensor (112).

4. The sensor device (100) of claim 3,
wherein the TMR sensor (111) is configured for being arranged in a first position towards the busbar (120) and the second TMR sensor (112) is configured for being arranged in a second position towards the busbar (120);
wherein a strength of the magnetic field (122) in the first position is different to a strength of the magnetic field (122) in the second position.

5. The sensor device (100) of claim 4, comprising:
the controller (115) configured to receive the sensor data from the TMR sensor (111) and the second sensor data from the second TMR sensor (112);
wherein the controller (115) is configured to detect an overdriving of the sensing resolution of the TMR sensor (111) by the magnetic field (122) based on the sensor data.

6. The sensor device (100) of claim 5,
wherein the controller (115) is configured to determine the current (121) flowing through the busbar (120) based on the sensor data and the second sensor data if no overdriving is detected and based on the second sensor data if the overdriving is detected.

7. The sensor device (100) of any of claims 2 to 6,
wherein the TMR sensor (111) is arranged at a first distance (201) to the busbar (120) and the second TMR sensor (112) is arranged at a second distance (202) to the busbar (120).

8. The sensor device (100) of claim 7,
wherein the second distance (202) is greater than the first distance (201).

9. The sensor device (100) of claim 7 or 8, comprising:
an encapsulant (220) encapsulating the carrier (110) and the TMR sensors (111, 112), the encapsulant (220) having a main surface being configured for placement on the busbar (120);
wherein the encapsulant (220) is dimensioned to arrange the TMR sensor (111) at the first distance (201) to the busbar (120) and the second TMR sensor (112) at the second distance (202) to the busbar (120).

10. The sensor device (100) of any of claims 2 to 9, comprising:
a second carrier (211) arranged above the carrier (110), wherein the second TMR sensor (112) is placed on the second carrier (211).

11. The sensor device (100) of claim 10, comprising:
one or more spacers (212) mounted between the carrier (110) and the second carrier (211),
wherein a height of the spacers (212) is dimensioned to place the second TMR sensor (112) on the second carrier (211) at the second distance (202) to the busbar (120).

12. The sensor device (100) of any of claims 2 to 9,
wherein both TMR sensors (111, 112) are placed on the carrier (110);
wherein an offset (111b) of the TMR sensor (111) towards the busbar (120) is different from an offset (112b) of the second TMR sensor (112) towards the busbar (120).

13. The sensor device (100) of any of claims 2 to 9, comprising:
a shielding plate (410) placed on the carrier (110), the shielding plate (410) being non-transparent to the magnetic field (122);
wherein the second TMR sensor (112) is separated from the busbar (120) with the shielding plate (401).

14. The sensor device (100) of any of claims 2 to 9,
wherein the TMR sensor (111) is placed on a top face (110a) of the carrier (110); and
wherein the second TMR sensor (112) is placed on a bottom face (110b) of the carrier (110), the bottom face (110b) being opposite to the top face (110a).

15. The sensor device (100) of any of claims 2 to 9,
wherein both TMR sensors (111, 112) are placed on the carrier (110);
wherein a position of the second TMR sensor (112) on the carrier (110) is rotated with respect to a position of the TMR sensor (111) on the carrier (110).

16. A method (700) for sensing a current (121) flowing through a busbar (120) in a battery-supplied vehicle, the method 8700) comprising:
placing (701) a carrier with a Tunnel Magneto-Resistance (TMR) sensor above or under the busbar;
sensing (702) a magnetic field generated by the current flowing through the busbar by the TMR sensor; and
providing (703) sensor data of the sensed magnetic field by a sensor interface of the TMR sensor to a controller for determining the current flowing through the busbar based on the sensor data of the TMR sensor.

17. The method (700) of claim 16,
wherein a second TMR sensor (112) is arranged on or above the carrier (110); the method (700) further comprising:
sensing the magnetic field by the second TMR sensor (112); and
providing second sensor data of the sensed magnetic field by a sensor interface of the second TMR sensor to the controller for determining the current flowing through the busbar based on the second sensor data of the second TMR sensor.

18. A sensing arrangement for sensing a current (121) flowing through a busbar (120) in a battery-supplied vehicle, the sensing arrangement comprising:
the sensor device (100) according to any of claims 1 to 15; and
the busbar (120);
wherein the carrier (110) of the sensor device (100) is placed above or under the busbar (120).
